(19) Europäisches Patentamt
European Patent Office
Office européen des brevets

(11) **EP 1 961 279 B1**

(12) **FASCICULE DE BREVET EUROPEEN**

(45) Date de publication et mention
de la délivrance du brevet:
**19.08.2015 Bulletin 2015/34**

(21) Numéro de dépôt: **06842093.4**

(22) Date de dépôt: **05.12.2006**

(51) Int Cl.:
*F02P 9/00* (2006.01)     *F02P 23/04* (2006.01)
*H01J 37/32* (2006.01)     *H05H 1/46* (2006.01)
*F02P 17/12* (2006.01)

(86) Numéro de dépôt international:
**PCT/FR2006/051282**

(87) Numéro de publication internationale:
**WO 2007/071865 (28.06.2007 Gazette 2007/26)**

(54) **OPTIMISATION DE LA FREQUENCE D'EXCITATION D'UN RESONATEUR**

OPTIMIERUNG DER ERREGUNGSFREQUENZ EINES RESONATORS

OPTIMIZATION OF THE EXCITATION FREQUENCY OF A RESONATOR

(84) Etats contractants désignés:
**AT BE BG CH CY CZ DE DK EE ES FI FR GB GR
HU IE IS IT LI LT LU LV MC NL PL PT RO SE SI
SK TR**

(30) Priorité: **15.12.2005 FR 0512769**

(43) Date de publication de la demande:
**27.08.2008 Bulletin 2008/35**

(73) Titulaire: **Renault s.a.s.
92100 Boulogne Billancourt (FR)**

(72) Inventeurs:
• **AGNERAY, André
F-92100 Boulogne (FR)**
• **NOUVEL, Clément
F-78480 Verneuil Sur Seine (FR)**
• **COUILLAUD, Julien
F-91200 Athismon (FR)**

(74) Mandataire: **Rougemont, Bernard et al
Renault s.a.s
Technocentre
Sce 00267 TCR GRA 2 36
1, Avenue du Golf
78288 Guyancourt (FR)**

(56) Documents cités:
**EP-A- 0 434 217          FR-A- 2 649 759
US-A- 5 513 618          US-A- 5 568 801
US-A1- 2004 237 950**

**Description**

L'invention concerne l'alimentation de résonateurs par des tensions supérieures à 100 V et des fréquences supérieures à 1 MHz et en particulier l'alimentation de résonateurs utilisés dans des générateurs de plasma.

Pour une application à un allumage automobile à génération de plasma, des résonateurs dont la fréquence de résonance est supérieure à 1 MHz sont disposés au niveau de la bougie et sont typiquement alimentés avec des tensions supérieures à 100 V et soumis à une intensité supérieure à 10A. Cette application nécessite l'utilisation de résonateurs radio-fréquence présentant un facteur de qualité élevé et un générateur haute tension dont la fréquence de fonctionnement est très proche de la fréquence de résonance du résonateur. Plus la différence entre la fréquence de résonance du résonateur et la fréquence de fonctionnement du générateur est réduite, plus le facteur d'amplification du résonateur (rapport entre sa tension de sortie et sa tension d'entrée) est élevé. Plus le facteur de qualité du résonateur est élevé, plus la fréquence de fonctionnement du générateur doit être proche de sa fréquence de résonance.

De nombreux paramètres ont une incidence sur la fréquence de résonance : les dispersions de fabrication, la température dans la chambre de combustion ou dans le circuit de refroidissement ou les dérives de vieillissement des composants du résonateur. Ces paramètres ont une incidence encore plus importante pour le cas particulier des bobines bougies. Ainsi, il est délicat de garantir un facteur d'amplification du résonateur.

L'invention vise à résoudre cet inconvénient. Il est connu le document FR2649759 qui divulgue un dispositif d'allumage pour moteur à combustion interne. Une source de tension alternative alimente un circuit résonant, notamment à la fréquence de résonance pour provoquer un arc électrique d'allumage entre des électrodes d'une bougie. Un oscillateur est disposé pour commander en fréquence la source de tension alternative. Le dispositif comprend en outre des moyens pour ajuster la fréquence de l'oscillateur, après l'amorçage, à une valeur assurant l'entretien de l'arc et des moyens pour couper cet arc après l'écoulement d'une durée prédéterminée. L'invention propose ainsi un dispositif d'alimentation d'un générateur de plasma radiofréquence, comprenant :

- une interface de réception d'une requête de détermination d'une fréquence de commande optimale ;
- une interface de sortie destinée à être connectée à un résonateur de génération de plasma ;
- un module d'alimentation appliquant sur l'interface de sortie une tension à une fréquence de consigne, cette tension étant sélectivement inapte à permettre la génération de plasma du résonateur lors de la réception d'une requête ou apte à permettre la génération de plasma du résonateur ;
- une interface de réception d'une mesure électrique de l'alimentation du résonateur ;
- un module de détermination de la fréquence de commande optimale, fournissant successivement différentes fréquences de consigne au module d'alimentation lors de la réception d'une requête, et déterminant une fréquence de commande optimale en fonction de mesures électriques reçues.

D'autres caractéristiques et avantages de l'invention ressortiront clairement de la description qui en est faite ci-après, à titre indicatif et nullement limitatif, en référence aux dessins annexés, dans lesquels :

- la figure 1 illustre schématiquement un dispositif de génération de plasma selon l'invention ;
- la figure 2 illustre un algorithme d'un exemple de mise en oeuvre de l'invention ;
- la figure 3 illustre un mode de réalisation d'un dispositif de génération de plasma selon l'invention ;
- la figure 4 illustre un premier exemple de signaux de commande applicables sur l'interrupteur de la figure 3 ;
- la figure 5 illustre un second exemple de signal de commande applicable sur l'interrupteur de la figure 3 ;
- la figure 6 illustre un premier exemple de circuit de mesure d'un paramètre électrique du résonateur de la figure 3 ;
- la figure 7 illustre un second exemple de circuit de mesure d'un paramètre électrique du résonateur de la figure 3.

L'invention propose d'alimenter un générateur de plasma radiofréquence de façon distincte durant une phase de fonctionnement du générateur et durant une phase d'optimisation de la fréquence d'alimentation de ce générateur. Lorsque la détermination d'une fréquence de commande optimale est requise, un signal d'amplitude ou de forme spécifique est appliquée aux bornes du résonateur afin de ne pas aboutir à la génération d'un plasma. Une tension dont on modifie la fréquence est appliquée sur le résonateur, une mesure électrique de l'alimentation du résonateur étant effectuée pour chaque fréquence appliquée. On détermine alors la fréquence de commande optimale en fonction des mesures électriques effectuées.

Les mesures électriques étant effectuées sans que le résonateur ne génère de plasma, ces mesures subissent moins de perturbations et nécessitent un moindre dimensionnement des composants de mesure. On peut ainsi réaliser un asservissement en boucle fermée de la fréquence d'alimentation du résonateur particulièrement précis. La fréquence de commande est ainsi maintenue très proche de la fréquence de résonance du résonateur, même lorsque cette fréquence de résonance tend à varier.

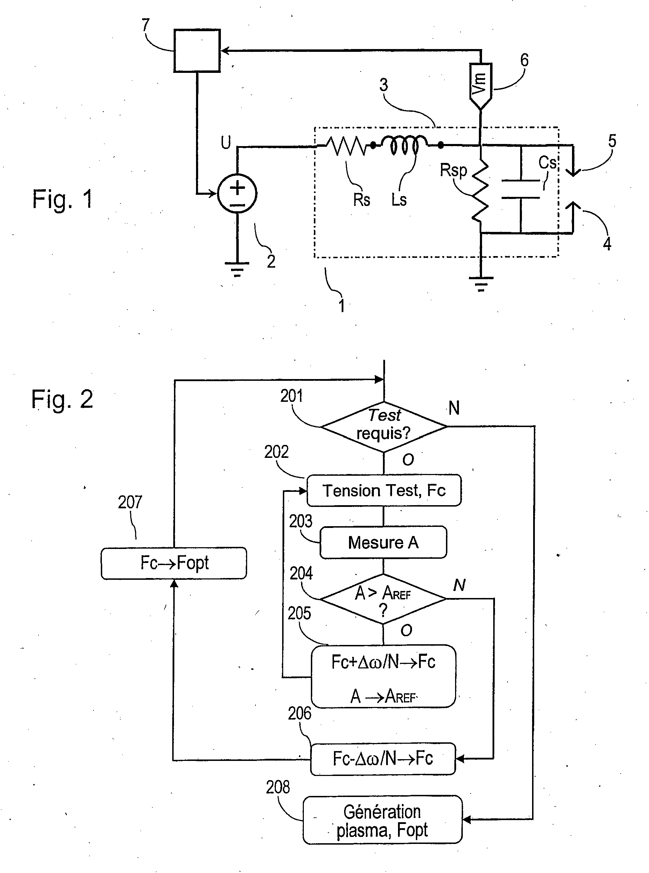

La figure 1 illustre un dispositif de génération de plasma 1. Ce dispositif 1 est muni d'un résonateur série 3 de génération de plasma. Le résonateur 3 comprend une résistance Rs en série avec une inductance Ls, et une résistance Rsp en parallèle avec une capacité Cs. Des électrodes d'allumage 4 et 5 sont connectées aux bornes de la capacité Csp.

Le dispositif 1 est également muni d'un dispositif d'alimentation. Ce dispositif d'alimentation comprend notamment un module d'alimentation 2 appliquant une tension de sortie U sur une interface de sortie à laquelle est connectée le résonateur série 3. Le module 2 applique sur l'interface de sortie une tension à une fréquence de consigne. Un module de commande 7 fournit la fréquence de consigne au module d'alimentation 2.

Afin de déterminer une fréquence de commande optimale pour la tension U, le module de commande 7 reçoit une requête de détermination d'une fréquence de commande optimale sur une interface non représentée. La fréquence de commande optimale est une fréquence de commande se rapprochant le plus possible de la fréquence de résonance du résonateur 3. Lors de la réception d'une telle requête, le module 2 applique sur l'interface de sortie une tension qui ne permet pas au résonateur 3 de générer un plasma. Lors de la réception d'une telle requête, le module 7 fournit également successivement différentes fréquences de consigne au module d'alimentation 2.

On réalise une mesure électrique du comportement du résonateur 3, par exemple en utilisant le voltmètre 6 mesurant la tension Vm. Pour chaque fréquence de consigne fournie, le module 7 relève une mesure électrique (par l'intermédiaire d'une interface de réception non illustré) et détermine alors une fréquence de commande optimale en fonction de ces mesures électriques. Les mesures électriques permettent par exemple de déterminer une fréquence de consigne la plus proche de la fréquence de résonance du résonateur 3, cette fréquence de consigne étant alors utilisée comme fréquence de commande optimale. La fréquence de commande optimale est alors mémorisée, puis utilisée comme fréquence de consigne pour le module d'alimentation 2, lors d'une phase de fonctionnement du dispositif 1 durant laquelle un plasma doit être généré entre les électrodes 4 et 5.

Le dispositif de génération de plasma 1 peut comprendre un résonateur de génération de plasma adapté pour réaliser un allumage commandé de moteur à combustion, adapté pour réaliser un allumage dans un filtre à particules ou adapté pour réaliser un allumage de décontamination dans un système de climatisation.

La figure 2 illustre un exemple d'algorithme de détermination d'une fréquence de commande optimale. Lors d'une étape 201, on vérifie si une requête de test a été reçue.

En l'absence de requête de test, on passe à l'étape 208 et un plasma est généré par le résonateur 3 en utilisant la fréquence de commande optimale pour la tension appliquée au résonateur. Le module d'alimentation 2 applique alors sur le résonateur 3 une tension adéquate pour la génération d'un plasma, de façon connue en soi.

En présence d'une requête de test, une tension de test est appliquée par lé module d'alimentation 2 sur le résonateur 3 durant l'étape 202. Cette tension est appliquée à une fréquence de consigne fc prédéterminée, cette tension étant telle qu'un plasma ne puisse pas être généré par le résonateur 3. Le fréquence fc prédéterminée est par exemple une fréquence que l'on sait avec certitude être inférieure ou supérieure à la fréquence optimale de commande. Dans l'exemple illustré, la fréquence fc prédéterminée est inférieure à la fréquence de résonance du résonateur.

Lors de l'étape 203, on réalise une mesure électrique A de l'alimentation du résonateur, cette mesure étant représentative de l'écart entre la fréquence de consigne et la fréquence de résonance. Dans l'exemple, on suppose que la mesure électrique croit à mesure que l'écart entre la fréquence de consigne et la fréquence de résonance diminue. Des exemples de mesures électriques seront détaillés ultérieurement.

Lors de l'étape 204, la mesure A est comparée à une référence Aref, dont la valeur initiale est prédéterminée. Si la mesure A dépasse la référence Aref, la valeur fc est augmentée et la référence Aref est mise à jour avec la mesure A lors de l'étape 205. Les étapes 202 à 204 sont alors répétées avec les nouvelles valeurs de fc et de Aref.

Lorsqu'on a déterminé à l'étape 204 que la mesure A est inférieure à la référence Aref, on détermine que la fréquence optimale de commande était la précédente fréquence de consigne. Lors de l'étape 206, on met à jour la fréquence de consigne avec sa valeur précédente. Lors de l'étape 207, on fixe la fréquence optimale de commande Fopt à cette valeur de la fréquence de consigne. La fréquence Fopt peut alors être utilisée pour la génération de plasma à l'étape 208.

La fréquence de commande optimale peut également être déterminée en extrapolant une courbe caractéristique d'un paramètre électrique du résonateur en fonction de la fréquence d'excitation, ce paramètre étant maximal pour la fréquence de résonance. La courbe est extrapolée sur la base de plusieurs mesures de l'alimentation du résonateur. Ainsi, si l'on veut approximer un paramètre électrique du résonateur par un polynôme du second degré, on effectue trois mesures électriques A1, A2 et A3 de ce paramètre pour 3 fréquences de consigne respectives différentes f1, f2 et f3.

Il suffit alors de résoudre le système linéaire suivant pour déduire les valeurs de a, b et c :

$$A1 = a*f_1^2 + b*f_1 + c$$
$$A2 = a*f_2^2 + b*f^2 + c$$
$$A3 = a*f_3^2 + b*f_3 + c$$

La fréquence de résonance est alors obtenu pour le maximum de la courbe, c'est-à-dire pour la valeur $F_{res} = -b/2a$.

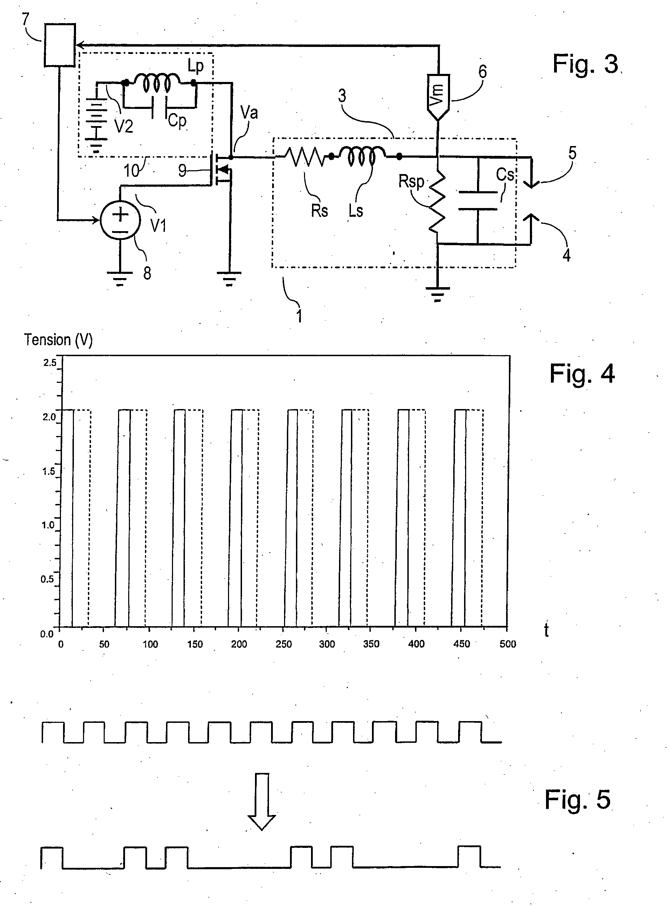

La figure 3 représente un mode de réalisation d'un dispositif de génération de plasma selon l'invention. Le module 7 fournit une fréquence de consigne à un générateur de signal de commande 8. Ce générateur 8 applique une tension de commande V1 à la fréquence de consigne fc sur la grille d'un transistor MOSFET de puissance 9. Le transistor 9 fait office d'interrupteur commandé par ce signal de commande. Le transistor 9 permet l'application de la tension Va sur l'interface de sortie connectée au résonateur.

Comme décrit dans la demande de brevet EP-A-1 515 594, un circuit résonant parallèle 10 est connecté entre une source de tension intermédiaire V2 et le drain du transistor 9. Ce circuit 10 comprend une inductance Lp et une capacité Cp.

La figure 4 illustre un exemple de signal de commande appliqué par le générateur 8 sur la grille du transistor 9. Les traits continus représentent le signal dé commande lors de la réception d'une requête de détermination d'une fréquence de commande optimale, les traits discontinus représentent le signal de commande lors d'une commande de génération de plasma. Afin d'éviter de générer un plasma lors de l'optimisation, le rapport cyclique du signal de commande est réduit de façon adéquate par rapport à une commande de génération de plasma. Ainsi, l'inductance Ls de la figure 3 n'est pas chargée pendant une durée suffisante pour permettre au résonateur 3 de générer un plasma. Les fréquences de consigne utilisées pour le signal de commande durant l'optimisation sont alors de l'ordre de grandeur de la fréquence de résonance du résonateur 3. Un tel signal de commande peut avantageusement être utilisé sans réduire la tension V2, afin de ne pas augmenter la complexité du dispositif de génération de plasma 1.

La figure 5 illustre un autre exemple de signal de commande appliqué par le générateur 8 sur la grille du transistor 9. Le diagramme supérieur correspond à un signal de commande de génération de plasma, le diagramme inférieur correspondant au signal de commande durant une optimisation.

Lors de la génération d'un plasma, le signal de commande est un train d'impulsions régulier, dont la fréquence est de l'ordre de grandeur de la fréquence de résonance du résonateur 3. Afin de ne pas générer de plasma durant l'optimisation, le train d'impulsions du signal de commande d'optimisation ne comprend qu'une partie des impulsions du signal de commande de génération de plasma correspondant. Ainsi, dans l'exemple, deux impulsions successives sur quatre ont été retirées du train d'impulsions. Même si la fréquence de commutation du transistor 9 n'est alors plus de l'ordre de grandeur de la fréquence de résonance du résonateur 3, des harmoniques de faible amplitude des impulsions appliquées sur le résonateur permettent d'exciter le résonateur 3 pour déterminer la fréquence de commande optimale à utiliser lors de la génération de plasma.

On peut également envisager d'empêcher la génération de plasma lors de l'optimisation en utilisant un niveau de tension intermédiaire V2 réduit, par rapport au niveau de la tension V2 utilisé lors de la génération de plasma.

Les règles suivantes peuvent notamment être utilisées pour déterminer des pas de fréquence pour la fréquence de consigne durant l'optimisation.

Sur la base du schéma de la figure 1, on détermine la pulsation propre du résonateur 3 :

$$\omega 0 = \sqrt{\frac{Rs + Rsp}{Ls * Cs * Rsp}}$$

On pose :

$$\xi = \frac{1}{2}\sqrt{\frac{Rsp}{Rsp + Rs}}\left(\frac{1}{Rsp}\sqrt{\frac{Ls}{Cs}} + Rs\sqrt{\frac{Cs}{Ls}}\right)$$

A la résonance, $\omega = \omega_0$ et $Vm(\omega_0) = V_{MAX}$. On peut alors définir le rapport

$$\left|\frac{V\max}{U}\right| = \frac{Rsp}{Rsp + Rs} * \frac{1}{2\xi}$$

Avec le dimensionnement du circuit utilisé, Rsp» Rs. Par conséquent,

$$\left|\frac{V\max}{U}\right| = \frac{1}{2\xi}$$

Pour une pulsation distincte de la pulsation de résonance, on obtient le rapport suivant :

$$\left|\frac{Vm}{U}\right| = \frac{Rsp}{Rsp + Rs} * \frac{1}{\sqrt{1 + (4\xi^2 - 2)\dfrac{\omega^2}{\omega_0{}^2} + \dfrac{\omega^4}{\omega_0{}^4}}} = A$$

Ce coefficient A peut être à la discrétion du fabricant du dispositif de génération de plasma. Ce coefficient A permet de définir une plage dans laquelle doit être incluse là pulsation de résonance de chaque résonateur de génération de plasma.

Par conséquent, en connaissant au préalable les valeurs de A et U, on peut déterminer la précision minimale en pulsation nécessaire pour qu'un système asservi utilise une pulsation dans cette plage.

Soient $\omega_1$ et $\omega_2$ tels que $Vm(\omega_1) = Vm(\omega_2) = A*U$

Soit $\Delta\omega = |\omega_1 - \omega_2|$, pour que la pulsation générée par le système asservi appartienne à ladite plage, le pas d'asservissement doit être au maximum de $\Delta\omega/2$. Ainsi, pour une précision maximale de l'asservissement de la pulsation, on utilisera un pas d'asservissement de $\Delta\omega/N$ avec N un entier prenant la plus grande valeur possible.

Pour atteindre la pulsation optimale d'excitation du résonateur de génération de plasma, le système asservi modifiera la pulsation par incréments de $\Delta\omega/N$. La mesure de Vm permet de déterminer la pulsation $\omega$ pour laquelle :

$\omega = \omega_{ref} + i*\Delta\omega/N \approx \omega_0$, avec i un entier signé et $\omega_{ref}$ une pulsation de référence utilisée au départ de l'asservissement en pulsation.

On peut étudier la réponse de la tension Vm à un train de créneaux périodiques de la tension U, dont la pulsation est calée sur la pulsation de résonance $\omega_0$.

En posant n un nombre entier, on exprime la tension U(t) de la façon suivante :

$U(t) = 0$ si $2n*\pi/\omega_0 < t < (2n+1)*\pi/\omega_0$
$U(t) = U_0$ si $(2n+1)*\pi/\omega_0 \leq t \leq (2n+2)*\pi/\omega_0$

Au n$^{ième}$ créneau, on obtient les tensions maximales et minimales suivantes :

$Vmax((2n+1)*\pi/\omega_0)\,U_0* (1 + (e^{-(n+1)\xi\pi} - e^{-\xi\pi})\,/(e^{-\xi\pi} - 1))$
$Vmin\,(2n*\pi/\omega_0) = -U_0* (1 + (e^{-(n+1)\xi\pi} - e^{-\xi\pi})\,/(e^{-\xi\pi} - 1))$

On obtient alors :

$Vmax\,((2n+1)*\pi/\omega_0) \rightarrow U_0/\xi\pi$ lorsque $n \rightarrow \infty$
$Vmin\,(2n*\pi/\omega_0) \rightarrow -U_0/(e^{-\xi\pi} - 1)$ lorsque $n \rightarrow \infty$

La mesure électrique de l'alimentation du résonateur est destinée à caractériser le coefficient de surtension Q=Vm/Va du résonateur 3. Différents paramètres, indépendants de la tension intermédiaire V2, peuvent être mesurés afin d'obtenir une mesure représentative du coefficient de surtension.

On peut par exemple calculer des admittances, sur la base d'une mesure du courant Im traversant le résonateur 3 et sur la base de différentes tensions.

On peut par exemple définir les admittances suivantes :

Ad=Im/Vm; cette admittance implique la détermination de la tension Vm et du courant Im ;
Ai=Im/Va=Ad*Q; bien que les valeurs de Q et Ad varient en fonction de la fréquence d'excitation du résonateur, Q varie plus rapidement que Ad à l'approche de la résonance. Ainsi, le maximum de Ai correspond au maximum de Q ;
Aa=Im/V2; pour cette admittance, on peut supposer que la valeur de V2 est constante et se contenter de mesurer le courant Im.

On peut bien entendu utiliser également toute autre mesure de paramètre électrique adéquate dont la variation en fonction de la fréquence permet de déterminer la fréquence optimale de commande.

Les valeurs de ces admittances étant maximales lorsque la fréquence d'excitation du résonateur est égale à sa fréquence de résonance, ces paramètres électriques permettent de déterminer la fréquence optimale de commande.

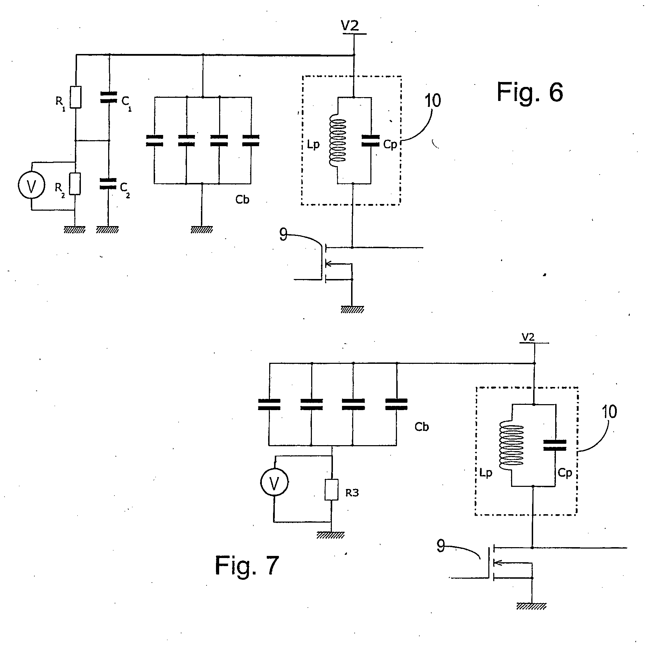

Les figures 6 et 7 illustrent des exemples de moyens pour effectuer une mesure électrique de l'alimentation du résonateur.

Sur la figure 6, un pont diviseur de tension est formé en respectant la relation R2*C2=R1*C1, les capacités C1 et C2 étant des capacités de stockage. La mesure de tension aux bornes de R2 permet de déduire l'énergie consommée par un train d'impulsions.

Sur la figure 7, on mesure la tension aux bornes d'une résistance R3, afin de mesurer le courant traversant les capacités Cb lors de l'ouverture du transistor 9.

Une variante permet également de détecter un dysfonctionnement du résonateur, dans une application à un moteur à combustion. L'invention propose ainsi un dispositif de détection de dysfonctionnement basé sur la détermination d'une fréquence de référence en fonctionnement normal. Ce dispositif de détection comprend :

- une interface de réception de signaux de mesures de paramètres de fonctionnement du moteur à combustion ;
- une interface de sortie d'un signal de référence ;
- un module mémoire mémorisant des relations entre des signaux de mesure et la fréquence d'un signal de référence en fonctionnement normal du moteur à combustion ;
- un module déterminant la fréquence d'un signal de référence en fonction de signaux de mesures reçus sur l'interface de réception et des relations mémorisées dans le module mémoire.

Un module de comparaison compare la fréquence de référence à la fréquence de commande optimale déterminée par le dispositif d'alimentation. Lorsque l'écart entre ces fréquences dépasse un seuil prédéterminé, le dispositif de détection de dysfonctionnement du résonateur génère un signal d'erreur.

## Revendications

1. Dispositif d'alimentation d'un générateur de plasma radiofréquence, **caractérisé en ce qu'**il comprend :

   - une interface de réception d'une requête de détermination d'une fréquence de commande optimale ;
   - une interface de sortie destinée à être connectée à un résonateur de génération de plasma ;
   - un module d'alimentation (2) configuré pour appliquer sur l'interface de sortie une tension à une fréquence de consigne, cette tension étant, en fonction de sa fréquence, sélectivement inapte à permettre la génération de plasma du résonateur lors de la réception d'une requête durant une phase d'optimisation de la fréquence d'alimentation dudit générateur et apte à permettre la génération de plasma du résonateur durant une phase de fonctionnement dudit générateur;
   - une interface de réception d'une mesure électrique de l'alimentation du résonateur ;
   - un module (7) de détermination de la fréquence de commande optimale, configuré pour fournir successivement différentes fréquences de consigne au module d'alimentation (2) lors de la réception d'une requête, et pour déterminer une fréquence de commande optimale en fonction de mesures électriques reçues par l'interface de réception.

2. Dispositif selon la revendication 1, dans lequel le module (7) de détermination de la fréquence de commande optimale détermine une fréquence de commande optimale sensiblement égale à la fréquence de résonance du résonateur de génération de plasma.

3. Dispositif selon la revendication 1 ou 2, dans lequel le module d'alimentation (2) comprend :

   - un générateur d'un signal de commande à la fréquence de consigne ;
   - un interrupteur (9) commandé par le signal de commande et connecté à l'interface de sortie.

4. Dispositif selon la revendication 3, dans lequel, lors de la réception d'une requête de détermination d'une fréquence de commande optimale, la fréquence du signal de consigne est de l'ordre de grandeur de la fréquence de résonance du résonateur destiné à être connecté à l'interface de sortie et le générateur de signal de commande réduit le rapport cyclique du signal de commande.

5. Dispositif selon la revendication 3 ou 4, dans lequel, lors de la réception d'une requête de détermination d'une fréquence de commande optimale, le signal de commande généré comprenant une partie des impulsions d'un train d'impulsions réguliers ayant une fréquence de l'ordre de grandeur de la fréquence de résonance du résonateur destiné à être connecté à l'interface de sortie.

**6.** Dispositif selon l'une quelconque des revendications précédentes, dans lequel le niveau de tension crête appliqué sur l'interface de sortie est réduit lors de la réception d'une requête de détermination d'une fréquence de commande optimale.

**7.** Dispositif selon l'une quelconque des revendications précédentes, dans lequel le module (7) de détermination de la fréquence de commande optimale compare deux valeurs successives de mesures électriques reçues, modifie la fréquence de consigne dans un premier sens si la différence entre les valeurs successives présente un premier signe, détermine que la précédente fréquence de consigne est la fréquence de commande optimale si la différence entre les valeurs successives présente un second signe.

**8.** Dispositif de génération de plasma comprenant un dispositif d'alimentation selon l'une quelconque des revendications précédentes et un résonateur (3) de génération de plasma connecté à l'interface de sortie du dispositif d'alimentation.

**9.** Dispositif de génération de plasma selon la revendication 8, dans lequel le résonateur de génération de plasma est adapté pour réaliser un allumage dans l'une des mises en oeuvre suivantes : allumage commandé de moteur à combustion, allumage dans un filtre à particules, allumage de décontamination dans un système de climatisation.

**10.** Dispositif de génération de plasma selon la revendication 8 ou 9, comprenant un module de mesure électrique de l'alimentation du résonateur connecté à l'interface de réception d'une mesure électrique.

**11.** Dispositif de génération de plasma selon la revendication 9, dans lequel le résonateur de génération de plasma est adapté pour réaliser un allumage commandé de moteur à combustion, et comprenant un dispositif de détection de dysfonctionnement présentant :

- une interface de réception de signaux de mesures de paramètres de fonctionnement du moteur à combustion ;
- une interface de sortie d'un signal de référence ;
- un module mémoire mémorisant des relations entre des signaux de mesure et la fréquence d'un signal de référence en fonctionnement normal du moteur à combustion ;
- un module déterminant la fréquence d'un signal de référence en fonction de signaux de mesures reçus sur l'interface de réception et des relations mémorisées dans le module mémoire ;
- un module de comparaison comparant la fréquence de référence à la fréquence de commande optimale déterminée par le dispositif d'alimentation et générant un signal d'erreur lorsque l'écart entre ces fréquences dépasse un seuil prédéterminé.

**Patentansprüche**

**1.** Vorrichtung zur Versorgung eines Radiofrequenzplasmagenerators, **dadurch gekennzeichnet, dass** sie umfasst:

- eine Empfangsschnittstelle für eine Anfrage zur Bestimmung einer optimalen Steuerfrequenz;
- eine Ausgangsschnittstelle, die dazu bestimmt ist, an einen Plasmaerzeugungsresonator angeschlossen zu werden;
- ein Versorgungsmodul (2), das derart ausgeführt ist, dass es an die Ausgangsschnittstelle eine Spannung mit einer Sollfrequenz anlegt, wobei diese Spannung in Abhängigkeit von ihrer Frequenz selektiv ungeeignet ist, die Plasmaerzeugung des Resonators beim Empfang einer Anfrage während einer Optimierungsphase der Versorgungsfrequenz des Generators zu ermöglichen, und geeignet ist, die Plasmaerzeugung des Resonators während einer Funktionsphase des Generators zu ermöglichen;
- eine Empfangsschnittstelle für eine elektrische Messung der Versorgung des Resonators;
- ein Modul (7) zur Bestimmung der optimalen Steuerfrequenz, das derart ausgeführt ist, dass es nacheinander verschiedene Sollfrequenzen an das Versorgungsmodul (2) beim Empfang einer Anfrage liefert und eine optimale Steuerfrequenz in Abhängigkeit von elektrischen Messungen, die von der Empfangsschnittstelle empfangen werden, bestimmt.

**2.** Vorrichtung nach Anspruch 1, bei der das Modul (7) zur Bestimmung der optimalen Steuerfrequenz eine optimale Steuerfrequenz im Wesentlichen gleich der Resonanzfrequenz des Plasmaerzeugungsresonators bestimmt.

**3.** Vorrichtung nach Anspruch 1 oder 2, bei der das Versorgungsmodul (2) umfasst:

- einen Generator eines Steuersignals mit der Sollfrequenz;
- einen Schalter (9), der von dem Steuersignal gesteuert wird und an die Ausgangsschnittstelle angeschlossen ist.

4. Vorrichtung nach Anspruch 3, bei der beim Empfang einer Anfrage zur Bestimmung einer optimalen Steuerfrequenz die Frequenz des Sollsignals die Größenordnung der Resonanzfrequenz des Resonators hat, der dazu bestimmt ist, an die Ausgangsschnittstelle angeschlossen zu werden, und der Steuersignalgenerator das zyklische Verhältnis des Steuersignals reduziert.

5. Vorrichtung nach Anspruch 3 oder 4, bei der beim Empfang einer Anfrage zur Bestimmung einer optimalen Steuerfrequenz das erzeugte Steuersignal einen Teil der Impulse eines regelmäßigen Impulszuges mit einer Frequenz von der Größenordnung der Resonanzfrequenz des Resonators umfasst, der dazu bestimmt ist, an die Ausgangsschnittstelle angeschlossen zu werden.

6. Vorrichtung nach einem der vorhergehenden Ansprüche, bei der das Spitzenspannungsniveau, das an die Ausgangsschnittstelle angelegt wird, beim Empfang einer Anfrage zur Bestimmung einer optimalen Steuerfrequenz reduziert wird.

7. Vorrichtung nach einem der vorhergehenden Ansprüche, bei der das Modul (7) zur Bestimmung der optimalen Steuerfrequenz zwei aufeinanderfolgende empfangene elektrische Messwerte vergleicht, die Sollfrequenz in eine erste Richtung modifiziert, wenn die Differenz zwischen den aufeinanderfolgenden Werten ein erstes Vorzeichen aufweist, bestimmt, dass die vorhergehenden Sollfrequenz die optimale Steuerfrequenz ist, wenn die Differenz zwischen den aufeinanderfolgenden Werten ein zweites Vorzeichen aufweist.

8. Plasmaerzeugungsvorrichtung, umfassend eine Versorgungsvorrichtung nach einem der vorhergehenden Ansprüche und einen Plasmaerzeugungsresonator (3), der an die Ausgangsschnittstelle der Versorgungsvorrichtung angeschlossen ist.

9. Plasmaerzeugungsvorrichtung nach Anspruch 8, bei der der Plasmaerzeugungsresonator dazu vorgesehen ist, eine Zündung bei einem der folgenden Einsätze durchzuführen: gesteuerte Zündung eines Verbrennungsmotors, Zündung in einem Partikelfilter, Dekontaminierungszündung in einem Klimatisierungssystem.

10. Plasmaerzeugungsvorrichtung nach Anspruch 8 oder 9, umfassend ein Modul zur elektrischen Messung der Versorgung des Resonators, der an die Empfangsschnittstelle einer elektrischen Messung angeschlossen ist.

11. Plasmaerzeugungsvorrichtung nach Anspruch 9, bei der der Plasmaerzeugungsresonator dazu vorgesehen ist, eine gesteuerte Zündung eines Verbrennungsmotors durchzuführen, und umfassend eine Vorrichtung zur Erfassung einer Fehlfunktion, umfassend:

- eine Empfangsschnittstelle von Signalen von Funktionsparametermessungen des Verbrennungsmotors;
- eine Ausgangsschnittstelle eines Referenzsignals;
- ein Speichermodul, das Relationen zwischen Messsignalen und der Frequenz eines Referenzsignals bei Normalfunktion des Verbrennungsmotors speichert;
- ein Modul, das die Frequenz eines Referenzsignals in Abhängigkeit von Messsignalen, die an der Empfangsschnittstelle empfangen werden, und den in dem Speichermodul gespeicherten Relationen bestimmt;
- ein Vergleichsmodul, das die Referenzfrequenz mit der optimalen Steuerfrequenz, die von der Versorgungsvorrichtung bestimmt wurde, vergleicht und ein Fehlersignal erzeugt, wenn die Abweichung zwischen diesen Frequenzen eine vorbestimmte Schwelle überschreitet.

**Claims**

1. Power-supply device for a radiofrequency plasma generator, **characterized in that** it comprises:

- an interface for receiving a request to determine an optimal control frequency;
- an output interface intended to be connected to a plasma generation resonator;
- a power-supply module (2) configured to apply a voltage at a set frequency to the output interface, this voltage selectively, depending on its frequency, being unable to allow plasma generation by the resonator when receiving a request during a phase of optimizing the power-supply frequency of said generator and able to allow plasma generation during an operation phase of said generator;
- an interface for receiving an electrical measurement of the resonator power supply; and
- a module (7) for determining the optimal control frequency configured to successively provide various set frequencies to the power-supply module (2) when receiving a request, and to determine an optimal control frequency as a function of the electrical measurements received by the reception interface.

2. Device according to Claim 1, wherein the module (7) for determining the optimal control frequency determines an optimal control frequency approximately equal to the resonant frequency of the plasma generation resonator.

3. Device according to Claim 1 or 2, wherein the power-supply module (2) comprises:

- a generator of a control signal at the set frequency;
- a switch (9) controlled by the control signal and connected to the output interface.

4. Device according to Claim 3, wherein during reception of a request to determine an optimal control frequency, the frequency of the set signal is of the order of magnitude of the resonant frequency of the resonator intended to be connected to the output interface and the control signal generator reduces the duty cycle of the control signal.

5. Device according to Claim 3 or 4, wherein during reception of a request to determine an optimal control frequency the control signal generated includes part of the pulses of a regular pulse train having a frequency of the order of magnitude of the resonant frequency of the resonator intended to be connected to the output interface.

6. Device according to any one of the preceding claims, wherein the peak voltage level applied to the output interface is reduced when a request to determine an optimal control frequency is being received.

7. Device according to any one of the preceding claims, wherein the module (7) for determining the optimal control frequency compares two successive values of electrical measurements received, modifies the set frequency in a first direction if the difference between the successive values has a first sign, determines that the preceding set frequency is the optimal control frequency if the difference between the successive values has a second sign.

8. Plasma generation device comprising a power-supply device according to any one of the preceding claims and a plasma generation resonator (3) connected to the output interface of the power-supply device.

9. Plasma generation device according to Claim 8, wherein the plasma generation device is designed to produce an ignition in one of the following implementations: controlled ignition of a combustion engine, ignition in a particulate filter, decontamination ignition in an air conditioning system.

10. Plasma generation device according to Claim 8 or 9, comprising a module for electrically measuring the power supply of the resonator connected to the interface for receiving an electrical measurement.

11. Plasma generation device according to Claim 9, wherein the plasma generation resonator is designed to produce controlled ignition of a combustion engine and comprising a device for detecting malfunction having:

- an interface for receiving signals of measurements of operating parameters of the combustion engine;
- an interface for output of a reference signal;
- a memory module storing relations between measurement signals and the frequency of a reference signal in normal operation of the combustion engine; and
- a module determining the frequency of a reference signal as a function of signals of measurements received on the reception interface and of relations stored in the memory module; and
- a comparison module comparing the reference frequency with the optimal control frequency determined by the power-supply device and generating an error signal when the difference between these frequencies passes a predetermined threshold.

Fig. 1

Fig. 2

Fig. 3

Fig. 4

Tension (V)

Fig. 5

Fig. 6

Fig. 7

## RÉFÉRENCES CITÉES DANS LA DESCRIPTION

**Documents brevets cités dans la description**

- FR 2649759

- EP 1515594 A